# EUROPÄISCHE PATENTSCHRIFT

(11) **EP 2 478 420 B1**
(45) Veröffentlichungstag und Bekanntmachung des Hinweises auf die Patenterteilung: **16.11.2016**
(21) Anmeldenummer: 10757754.6
(22) Anmeldetag: 16.09.2010
(51) Int. Cl.: G05B 9/02, H04L 12/40, H04L 12/413, H04L 12/46, H04L 12/66

(54) **SCHALTUNGSANORDNUNG MIT EINEM UMRICHTERTEIL UMFASSEND EINE ZENTRALE STEUEREINHEIT**
CIRCUIT ASSEMBLY HAVING A CONVERTER DEVICE COMPRISING A CENTRAL CONTROL UNIT
CIRCUIT DOTÉ D'UNE PARTIE ONDULEUR COMPRENANT UNE UNITÉ DE COMMANDE CENTRALE

(30) Priorität: 17.09.2009 DE 102009041632
(43) Veröffentlichungstag der Anmeldung: 25.07.2012
(73) Patentinhaber: AEG Power Solutions GmbH, 59581 Warstein-Belecke (DE)
(72) Erfinder: BLACHA, Norbert, 59581 Warstein (DE); PECK, Andreas, 59519 Möhnesee (DE); BRAND, Dieter, 59581 Warstein (DE)
(74) Vertreter: Graefe, Jörg
(86) Internationale Anmeldenummer: PCT/EP2010/063627
(87) Internationale Veröffentlichungsnummer: WO 2011/033027

(56) Entgegenhaltungen:
- EP-A1- 1 031 420
- CN-Y- 2 906 709
- DE-A1-102005 029 655
- DE-A1-102007 047 890
- DE-A1-102007 049 313
- DE-B3-102007 050 031
- DE-U1-202005 007 220
- JP-A- S63 171 167
- US-A1- 2005 094 343

## Beschreibung

Die vorliegende Erfindung betrifft eine Schaltungsanordnung, insbesondere Wechselrichter oder unterbrechungsfreie Stromversorgung, mit einem Umrichterteil umfassend eine Umrichtereinheit, eine zentralen Steuereinheit und einen Eingang für den umzurichtenden Strom und einen Ausgang für den umgerichteten Strom und wenigstens einem Beschaltungsteil, der dem Eingang des Umrichterteils vorgeschaltet oder dem Ausgang des Umrichterteils nachgeschaltet ist, wobei an die Schaltungsanordnung wenigstens eine externe Steuereinheit anschließbar ist und dass die zentrale Steuereinheit zum Empfang von Steueranweisungen der externen Steuereinheit geeignet und eingerichtet ist.

Aus der Übersetzung der europäischen Patentschrift mit der Veröffentlichungsnummer DE 600 36 150 T2 ist ein Netz von Solarwechselrichtern bekannt, die ein Wechselrichterteil mit einer Wechselrichtereinheit und einen Mikrocomputer als zentrale Steuereinheit aufweisen. Das Netz weist Fernsteuerungen als externe Steuereinheiten auf, die mit dem Mikrocomputer verbunden ist, und mit welcher der Mikrocomputer gesteuert werden kann. Ferner kann die Fernsteuerung gezielt einen Schalter in einem eingangsseitigen Beschaltungsteil eines Solarwechselrichters betätigen.

Die Übersetzung der europäischen Patentschrift mit der Veröffentlichungsnummer DE 600 36 150 T2 beschreibt, wie die parallel an das Versorgungsnetz geschalteten Solarwechselrichter betrieben werden können.

Die Übertragungsnetzbetreiber oder Verteilnetzbetreiber, in deren Versorgungsnetze elektrische Energie eingespeist wird, machen detaillierte Vorschriften, wie der Netzanschluss zum Einspeisen von elektrischer Energie aus Fotovoltaikanlagen erfolgen muss. Insbesondere für Fotovöltaikanlagen mit Leistungen von größer als 30 kW sind dabei besondere Vorgaben zum Beispiel im Hinblick auf die Sicherheit gemacht. So muss gewährleistet sein, dass die Fotovoltaikanlage auch bei einem nur teilweisen Ausfall, beispielsweise des Solarwechselrichters schnell und möglichst ohne Rückwirkung auf das Versorgungsnetz von diesem getrennt werden kann. Ein ähnliches Problem kann sich bei unterbrechungsfreien Stromversorgungen ergeben.

Weiterer Stand der Technik ist den Dokumenten DE 10 2007 049 313 A1, DE 20 2005 007 220 U, DE 10 2007 047 890 A1, DE 10 2007 050 031 B3 offenbart.

Dieses Problem wird gemäß Vorrichtungsanspruch 1 und Verfahrensanspruch 15 dadurch gelöst, dass jeder Beschaltungsteil wenigstens eine dezentrale Steuereinheit aufweist, die mit der zentralen Steuereinheit über einen Kommunikationsbus verbunden ist und zum Empfang von Steueranweisungen von der zentralen Steuereinheit geeignet und eingerichtet ist, dass die externe Steuereinheit an den Kommunikationsbus anschließbar ist und die dezentrale Steuereinheit zum unmittelbaren Empfang von Steueranweisungen der externen Steuereinheit geeignet und eingerichtet ist.

Im Unterschied zu der Schaltungsanordnung, wie sie aus dem Dokument DE 600 36 150 T2 bekannt ist, ist es mit der erfindungsgemäßen Schaltungsanordnung möglich, dass eine externe Steuerungseinheit unmittelbar über den Kommunikationsbus auf dezentrale Steuerungseinheiten in dem Beschaltungsteil oder den Beschaltungsteilen einwirkt, um zum Beispiel eine vollständige Trennung der Schaltungsanordnung sowohl eingangsseitig als auch ausgangsseitig herzustellen. Damit kann die externe Steuereinheit auch bei einem Ausfall der zentralen Steuerungseinheit in dem Wechselrichterteil eingreifen. Dadurch, dass zum Informationsaustausch ein Kommunikationsbus genutzt wird, ist eine Erweiterung der Schaltungsanordnung um weitere Umrichterteile, Beschaltungsteile und/oder weitere dezentrale Steuerungseinheiten in den Beschaltungsteilen mit einfachen Mitteln möglich. Die Schaltungsanordnung ist dadurch gut skalierbar.

Durch die Verwerdung von dezentralen Steuerungseinheiten kann die zentrale Steuerungseinheit von untergeordneten Steuerungsaufgaben befreit werden, die dann von den dezentralen Steuerungseinheiten wahrgenommen werden.

Eine erfindungsgemäße Schaltungsanordnung kann eine Kommunikationseinheit aufweisen. Diese Kommunikationseinheit kann zwischen dem Kommunikationsbus und einem Anschluss der Schaltungsanordnung für die externe Steuereinheit angeordnet sein. Der Anschluss der Schaltungsanordnung für die externe Steuereinheit kann eine Schnittstelle zu einem öffentlichen Kommunikationsnetz umfassen. Die externe Steuereinheit kann also Steueranweisungen über das öffentliche Kommunikationsnetz an die Schaltungsanordnung geben. Die Kommunikationseinheit kann eine Schnittstelle zum Kommunikationsbus und eine Treiberschaltung für diese Schnittstelle umfassen.

Der Beschaltungsteil oder die Beschaltungsteile einer erfindungsgemäßen Schaltungsanordnung können Sicherungen, Schalter, insbesondere steuerbare Schalter z.B. Schütze, Messgrößen-Aufnehmer, Isolationswächter und vieles mehr aufweisen. Mit den Messgrößen-Aufnehmern können Messwerte über die dezentralen Steuereinheiten an die zentrale Steuereinheit und/oder auch in die externe Steuereinheit geliefert werden. Die zentrale Steuereinheit und/oder die externe Steuereinheit können dann in Reaktion auf die erfassten Messwerte Steueranweisungen an die dezentralen Steuereinheiten bzw. die zentrale Steuereinheit generieren. Die in den Beschaltungsteilen gewonnenen Messeinformationen können über die dezentralen Steuereinheiten vorzugsweise in dem Kommunikationsbus zur Verfügung gestellt werden.

Eine erfindungsgemäße Schaltungsanordnung kann mehrere Schaltschränke aufweisen. Der Umrichterteil kann in einem Schaltschrank angeordnet sein. Der Beschaltungsteil oder die Beschaltungsteile können ebenfalls in eigenen Schaltschränken angeordnet sein. Vorteilhaft ist es, wenn dem Umrichterteil und jedem Beschaltungsteil ein eigener Schaltschrank zugeordnet ist. Jeder Schaltschrank weist dann einen Abschnitt des Kommunikationsbus auf. Die Abschnitte des Kommunikationsbus können über Schnittstellen miteinander verbunden sein. Ferner weist jeder vorteilhafte Schaltschrank einen Netzanschluss für die Hilfsstromversorgung bzw. Stromversorgung der zentralen und/oder dezentralen Steuereinheiten auf.

Die zentrale Steuereinheit und die dezentralen Steuereinheiten weisen vorzugsweise jeweils eine eigene elektrische Energieversorgung auf. Damit können die Steuereinheiten unabhängig voneinander mit elektrischer Energie versorgt werden. Diese separate Energieversorgung kann zusätzlich zu einer Energieversorgung der dezentralen Steuereinheiten über die zentrale Steuereinheit erfolgen.

Die Schaltungsanordnung kann ein Wechselrichter, insbesondere ein Solarwechselrichter sein. Ein solcher Wechselrichter weist einen eingangsseitigen Beschaltungsteil und einen ausgangsseitigen Beschaltungsteil auf. Der eingangsseitige Beschaltungsteil ist dann im Betrieb des Wechselrichters an einen Generator, z.B. einen Solargenerator, und der ausgangsseitige Beschaltungsteil an ein Übertragungsnetz oder Verteilernetz angeschlossen, die auch als Versorgungsnetze bezeichnet werden.

Die Schaltungsanordnung kann aber auch eine unterbrechungsfreie Stromversorgung sein. Sie weist dann ein ausgangsseitiges Beschaltungsteil auf, wobei der Umrichterteil an einen Generator, einen Speicher für elektrische Energie oder ein Energie bereitstellendes Versorgungsnetz angeschlossen ist. Der ausgangsseitige Beschaltungsteil kann an ein zu versorgendes Netz angeschlossen werden, zum Beispiel an eine Hausinstallation.

Eine solche unterbrechungsfreie Stromversorgung kann eine zentrale elektronische Umschalteinrichtung mit einer Steuereinheit oder einen statischen Transferschalter mit einer Steuereinheit aufweisen. Diese Steuereinheiten können die externen Steuereinheiten bilden, die an die unterbrechungsfreie Stromversorgung angeschlossen werden können.

Aus einer oder mehrerer erfindungsgemäßen Schaltungsanordnungen und einer externen Steuereinheit kann ein Netz gebildet sein, wobei die externe Steuereinheit zum parallelen Steuern der zentralen und/oder dezentralen Steuereinheiten geeignet und eingerichtet ist. Die externe Steuereinheit kann ein Leitrechner des Netzes sein.

Das vorteilhafte an einem solchen erfindungsgemäßen Netz ist, dass es so betrieben werden kann, dass die externe Steuereinheit bei Ausfall der zentralen Steuereinheit eine der Schaltungsanordnungen die dezentralen Steuereinheiten dieser Schaltungsanordnung steuert und insbesondere ausschaltet.

Weitere Merkmale und Vorteile der vorliegenden Erfindung werden deutlich anhand der nachfolgenden Beschreibung bevorzugter Ausführungsbeispiele unter Bezugnahme auf die beiliegenden Abbildungen. Darin zeigen in schematischer Darstellung
Fig. 1 ein Netz aus einem erfindungsgemäßen Solarwechselrichter mit einer Verbindung zu mehreren externen Steuereinheiten,
Fig. 2 ein Netz aus mehreren erfindungsgemäßen Solarwechselrichtern und mehreren externen Steuereinheiten und
Fig. 3 ein Netz aus einer erfindungsgemäßen unterbrechungsfreien Stromversorgung und mehreren externen Steuereinheiten.

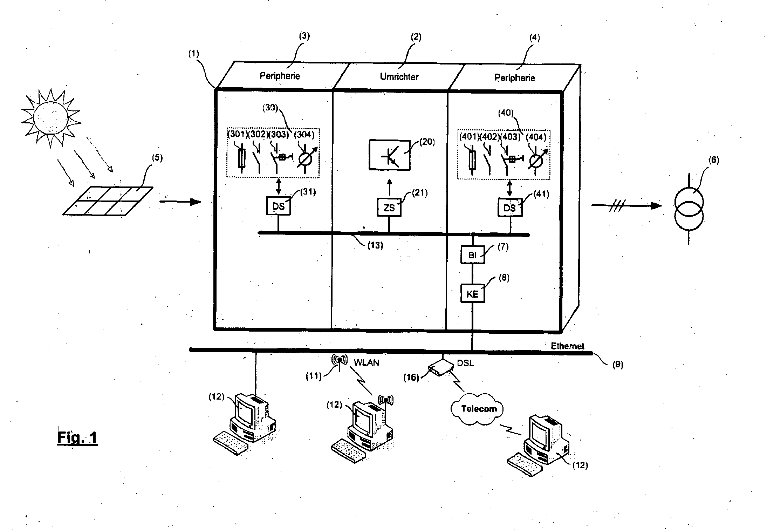

Der in Figur 1 dargestellte erfindungsgemäße Solarwechselrichter 1 weist ein Umrichterteil 2, ein eingangsseitiges Beschaltungsteil 3 und ein ausgangsseitiges Beschaltungsteil 4 auf. Der eingangsseitige Beschaltungsteil 3 ist mit einem Solargenerator 5 verbunden. In dem Solargenerator 5 wird Strahlungsenergie der Sonne in elektrische Energie gewandelt. Der Solargenerator 5 liefert einen Gleichstrom, der in dem Solarwechselrichter 1 in einen Wechselstrom gewandelt wird. Die Wandlung des Gleichstroms in einen Wechselstrom erfolgt im Umrichterteil 2. Über den ausgangsseitigen Beschaltungsteil 4 wird der Wechselstrom dann in ein Versorgungsnetz 6 eingespeist. Die Einspeisung kann dreiphasig erfolgen.

Im eingangsseitigen Beschaltungsteil können verschiedene Komponenten 30 vorgesehen sein. Bei den Komponenten kann es sich beispielsweise um Sicherungen 301, um Schalter 302, um Schütze 303, um Messgrößen-Aufnehmer, um Isolätionswächter 304 und vieles mehr handeln. Mit diesen Komponenten kann der Strom beispielsweise unterbrochen oder messtechnisch erfasst werden. Außerdem kann der Solarwechselrichter 1 durch Sicherungen 301 abgesichert sein.

Im Umrichterteil 2 ist eine Umrichtereinheit 20 vorgesehen, in welcher der über den eingangsseitigen Beschaltungsteil 3 in den Solarwechselrichter 1 eingespeiste Gleichstrom vom Solargenerator 5 in einen Wechselstrom gewandelt wird.

Über das ausgangsseitige Beschaltungsteil 4 wird der Wechselstrom dann dem Versorgungsnetz 6 zugeführt. Im ausgangseitigen Beschaltungsteil 4 sind verschiedene Komponenten 40 vorgesehen. Mit diesen Komponenten 40 kann der Strom beispielsweise geschaltet werden, messtechnisch erfasst oder überwacht werden. Ferner ist eine Absicherung des Solarwechselrichters 1 vor Rückwirkungen aus dem Versorgungsnetz 6 möglich. Bei den Komponenten 40 kann es sich daher um Sicherungen 401, Schalter 402, Schütze 403, Isolationswächter und Messgrößen-Aufnehmer 404 handeln.

Die Vorgänge in dem Solarwechselrichter 1 werden im Regelfall von einer zentralen Steuereinheit 21 gesteuert, überwacht und/oder geregelt. Die zentrale Steuereinheit 21 ist in dem Umrichterteil 2 vorgesehen. Neben der zentralen Steuereinheit 21 sind dezentrale Steuereinheiten 31, 41 in dem eingangsseitigen Beschaltungsteil 3 und dem ausgangsseitigen Beschaltungsteil 4 vorgesehen. Diese dezentralen Steuereinheiten 31, 41 sind mit den Komponenten 30, 40 in dem eingangsseitigen Beschaltungsteil 3 bzw. dem ausgangsseitigen Beschaltungsteil 4 verbunden, um diese zu Steuern, Regeln und/oder die von den Komponenten gelieferten Messgrößen auszuwerten und/oder an die zentrale Steuereinheit 21 weiterzuleiten.

Die Verbindung zwischen der zentralen Steuereinheit 21 und den dezentralen Steuereinheiten 31, 41 ist über einen Kommunikationsbus 13 hergestellt. Über den Kommunikationsbus werden alle Informationen, wie zum Beispiel Messwerte oder Steueranweisungen ausgetauscht. Die zentrale Steuereinheit 21 ist dabei eine übergeordnete Instanz, der die dezentralen Steuereinheiten 31, 41 nachgeordneten sind.

Der Solarwechselrichter 1 weist ferner ein Businterface 7 auf, dass ebenfalls an einen Kommunikationsbus 13 angeschlossen ist. Das Businterface 7 ist mit einer Kommunikationseinheit 8 verbunden, die ihrerseits eine Schnittstelle zu einem externen Netzwerk 9 aufweist.

An dem externen Netzwerk 9 sind verschiedene externe Steuereinheiten 12 angeschlossen. Der Anschluss erfolgt entweder unmittelbar über eine entsprechende Schnittstelle der externen Steuereinheit 12 zum Netzwerk oder unter Zwischenschaltung eines WLAN-Netzwerkes 11 oder eines öffentlichen Telekommunikationsnetzes über ein DSL-Modem 16.

Über die externen Steuereinheiten 11 ist ein Zugriff auf die zentrale Steuereinheit 21 aber auch auf die dezentralen Steuereinheiten 31, 41 möglich. Es können daher durch die externen Steuereinheiten 12 unmittelbare Vorgänge in dem eingangsseitigen Beschaltungsteil 3, dem Umrichterteil 2 und dem ausgangsseitigen Beschaltungsteil 4 gesteuert, geregelt oder überwacht bzw. gemessen werden. Das hat den Vorteil, dass auch bei einem Ausfall einer der Steuereinheiten innerhalb des Solarwechselrichters 1 die übrigen Steuereinheiten angesprochen werden, um den Solarwechselrichter 1 außer Betrieb zu setzen.

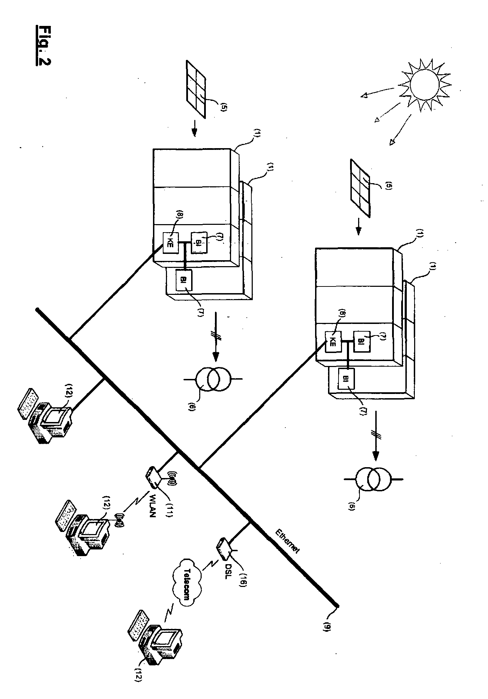

Ein derartiger Solarwechselrichter 1 kann mit einem weiteren Solarwechselrichter 1 zu einem Paar gekoppelt sein. Die beiden miteinander gekoppelten Solarwechselrichter 1 (siehe Figur 2) sind dann über ihre Businterfaces oder unmittelbar über den Kommunikationsbus 13 miteinander verbunden.

Ein einzelner Solarwechselrichter 1 aber auch ein Paar von Solarwechselrichtern 1 kann dann über die Kommunikationseinheit mit einem Netzwerk 9 verbunden sein, an dem andere Solarwechselrichter 1 oder Paare von Solarwechselrichtern 1 angeschlossen sind. Über ebenfalls an dem Netzwerk 9 angeschlossene externe Steuereinheiten 12 können die Solarwechselrichter 1 dann gesteuert, geregelt, gemessen oder überwacht werden. Steuereingriffe können dabei von einer externen Steuereinheit 12 gleichzeitig auf alle Solarwechselrichter 1 erfolgen. Selbstverständlich ist es auch möglich einen einzelnen oder einer Gruppe von Solarwechselrichtern 1 , die an dem Netzwerk 9 angeschlossen sind, zu Steuern, zu Regeln, zu Überwachen und so weiter.

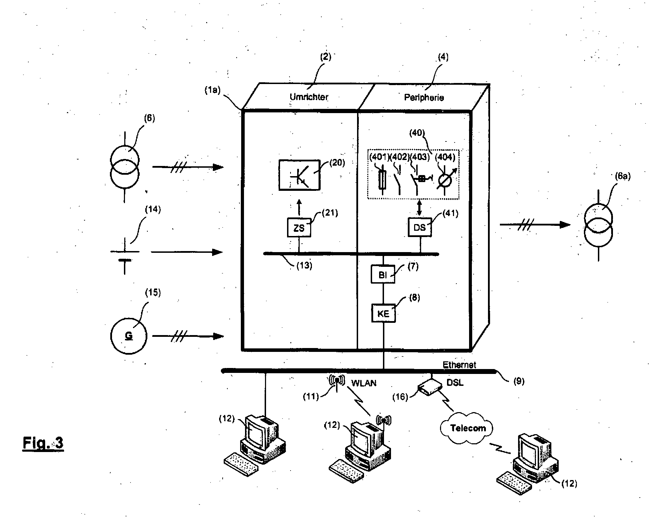

Die in Figur 3 dargestellte unterbrechungsfreie Stromversorgung 1a ist in gleicher Weise wie die beschriebenen Solarwechselrichter 1 von einer externen Steuereinheit 12 steuerbar oder regelbar oder kann von dieser überwacht werden. Die unterbrechungsfreie Stromversorgung 1a weist ebenfalls einen Umrichterteil 2 und einen ausgangsseitigen Beschaltuhgsteil 4 auf. Der Umrichterteils 2 wird unmittelbar aus einem Versorgungsnetz 6, einer Batterie 14 oder einem Generator 15 mit elektrischer Energie gespeist. Die elektrische Energie wird im Umrichterteil gegebenenfalls so umgeformt, dass sie über das ausgangsseitige Beschaltungsteil 4 in ein zu versorgendes Netz 6a eingespeist werden kann.

Der Umrichterteil 2 weist ebenfalls eine Umrichtereinheit 20 auf, die von einer zentralen Steuereinheit 21 überwacht, geregelt und/oder gesteuert wird. Die zentrale Steuereinheit 21 überdacht, regelt und/oder steuert außerdem eine dezentrale Steuereinheit 41 des ausgangsseitigen Beschaltungsteils 4. Die dezentrale. Steuereinheit 41 ihrerseits überwacht, steuert und/oder regelt Komponenten 40 in dem ausgangsseitigen Beschaltungsteil 4. Unter Zwischenschaltung der dezentralen Steuereinheit 41 hatalsoauch die zentrale Steuereinheit 21 Zugriff auf die Komponenten 40.

Bei den Komponenten 40 kann es sich um Sicherungen 401, Schalter 402, Schütze 403, Messgrößen-Aufnehmer 404 und vieles mehr handeln, mit dem man Strom und/oder Spannung Steuern, Regeln, Schalten und/oder überwachen kann.

Die zentrale Steuereinheit 21 ist über einen Kommunikationsbus 13 mit der dezentralen Steuereinheit 41 verbunden. Über ein Businterface 7 ist eine Kommunikationseinheit 8 an den Kommunikationsbus 13 angeschlossen. Die Kommunikationseinheit 8 ist außerdem mit einem externen Netzwerk 9 verbunden, über das eine Verbindung zu einer der externen Steuereinheiten 12 hergestellt werden kann. Die Verbindung zu den externen Steuereinheiten kann unmittelbar über das Netzwerk 9 erfolgen, wenn die externe Steuereinheit 12 direkt an dem Netzwerk 9 angeschlossen ist. Es kann aber auch beispielsweise ein WLAN-Netzwerk 11 oder ein öffentliches Telekommunikationsnetz zwischengeschaltet sein. In diesem Fall ist dann ein DSL-Modem 16 angeschlossen.

Die externen Steuereinheiten 12 können unmittelbar auf die dezentrale Steuereinheit 41 aber auch auf die zentrale Steuereinheit 21 zugreifen und die mit diesen Steuereinheiten 21, 41 verbundenen Komponenten 40 bzw. die Umrichtereinheit 20 Steuern, Regeln und/oder überwachen.

## Patentansprüche

1. Schaltungsanordnung (1, 1a), insbesondere Wechsetrichter (1) oder unterbrechungsfreie Stromversorgung (1a), mit einem Umrichterteil (2) umfassend eine Umrichtereinheit (20), eine zentrale Steuereinheit (21) und einen Eingang für den umzurichtenden Strom und einen Ausgang für den umgerichteten Strom und wenigstens ein Beschaltungsteil (3, 4), der dem Eingang des Umrichterteils vorgeschaltet oder dem Ausgang des Umrichterteils nachgeschaltet ist, wobei an die Schaltungsanordnung wenigstens eine externe Steuereinheit (12) anschließbar ist und dass die zentrale Steuereinheit (21) zum Empfang von Steueranweisungen der externen Steuereinheit (12) geeignet und eingerichtet ist,
**dadurch gekennzeichnet,**
**dass** jeder Beschaltungsteil (3, 4) wenigstens eine dezentrale Steuereinheit (31, 41) aufweist, die mit der zentralen Steuereinheit (21), die eine übergeordnete Instanz darstellt, über einen Kommunikationsbus (13) verbunden ist und zum Empfang von Steueranweisungen von der zentralen Steuereinheit (21) geeignet und eingerichtet ist, wobei die dezentrale Steuereinheit (31, 41) der zentralen Steuereinheit nachgeordnet ist,
**dass** die externe Steuereinheit (12) an den Kommunikationsbus (13) anschließbar ist und die dezentrale Steuereinheit (31, 41) zum unmittelbaren Empfang von Steueranweisungen der externen Steuereinheit (12) geeignet und eingerichtet ist, damit die externe Steuereinheit (12) bei Ausfall einer zentralen Steuereinheit (21) in die Schaltungsanordnung (1, 1a) eingreifen kann.

2. Schaltungsanordnung (1, 1a) nach Anspruch 1, **dadurch gekennzeichnet, dass** die Schaltungsanordnung (1, 1a), insbesondere der Umrichterteils (2) eine Kommunikationseinheit (7, 8) aufweisen, die zwischen dem Kommunikationsbus (13) und einem Anschluss der Schaltungsanordnung für die externe Steuereinheit (12) angeordnet ist.

3. Schaltungsanordnung (1, 1a) nach Anspruch 2, **dadurch gekennzeichnet, dass** der Anschluss der Schaltungsanordnung (1, 1a) für die externe Steuereinheit (12) eine Schnittstelle zu einem öffentlichen Kommunikationsnetz oder einem lokalen Netzwerk (9) umfasst.

4. Schaltungsanordnung (1, 1a) nach Anspruch 2 oder 3, **dadurch gekennzeichnet, dass** die Kommunikationseinheit (7, 8) eine Schnittstelle zum Kommunikationsbus (13) und eine Treiberschaltung (7) für diese Schnittstelle umfasst.

5. Schaltangsanordnung (1, 1a) nach einem der Ansprüche 1 bis 4, **dadurch gekennzeichnet, dass** der oder die Beschaltungsteile (3, 4) Sicherungen (301, 401), Schalter (302, 402), insbesondere steuerbare Schalter z. B. Schütze (303, 403), Messgrößen-Aufnehmer (304, 404), Isolationswächter u. v. m. aufweisen.

6. Schaltungsanordnung (1, 1a) nach einem der Ansprüche 1 bis 5, **dadurch gekennzeichnet, dass** die dezentralen Steuereinheiten (31, 41) geeignet und eingerichtet sind in dem Beschaltungsteil (3, 4) gewonnene Messinformationen auf dem Kommunikationsbus (9) zur Verfügung zu stellen.

7. Schaltungsanordnung (1, 1a) nach einem der Ansprüche 1 bis 6, **dadurch gekennzeichnet, dass** die Schaltungsanordnung (1, 1a) mehrere Schaltschränke aufweist und der Umrichterteil (2) in einem Schaltschrank angeordnet ist und der Beschaltungsteil (3, 4) oder die Beschaltungsteile (3, 4) in jeweils eigenen Schaltschränken angeordnet sind.

8. Schaltungsanordnung (1, 1a) nach einem der Ansprüche 1 bis 7, **dadurch gekennzeichnet, dass** die zentrale Steuereinheit (21) und die dezentrale Steuereinheiten (31 ,41) jeweils eigene elektrische Energieversorgungen aufweisen.

9. Schaltungsanordnung (1, 1a) nach Anspruch 8, **dadurch gekennzeichnet, dass** die dezentralen Steuereinheiten (31 ,41) zusätzlich über die Energieversorgung der zehtralen Steuereinheit (21) mit elektrischer Energie versorgbar sind.

10. Schaltungsanordnung (1, 1a) nach einem der Ansprüche 1 bis 9, **dadurch gekennzeichnet, dass** die Schaltungsanordnung (1, 1a) ein Wechselrichter (1) ist und ein eingangsseitiges Beschaltungsteil (3) und ein ausgangsseitiges Beschaltungsteil (4) aufweist, wobei der eingangsseitige Beschaltungsteil (3) an einen Generator, zum Beispiel einen Solargenerator (5) und der ausgangsseitige Beschaltungsteil an ein Versorgungsnetz (6) anschließbar ist.

11. Schaltungsanordnung (1, 1a) nach einem der Ansprüche 1 bis 9, **dadurch gekennzeichnet, dass** die Schaltungsanordnung (1, 1a) eine unterbrechungsfreie Stromversorgung (1) ist und einen ausgangsseitigen Beschaltungsteil (4) aufweist, wobei der Umrichterteil (2) an einen Generator (15), einen Speicher für elektrische Energie (14) oder ein Energie bereitstellendes Versorgungsnetz (6) und der ausgangsseitige Beschaltungsteil an ein zu versorgendes Netz (6ä) anschließbär ist.

12. Schaltungsanordnung (1, 1a) nach Anspruch **dadurch gekennzeichnet, dass** die Schaltungsanordnung (1, 1a) eine zentrale elektronische Umschalteinrichtung mit einer Steuereinheit oder einen statischen Transferschalter mit einer Steuereinheit aufweist und diese Steuereinheit die externe Steuereinheit (12) bildet.

13. Netz aus einer oder mehreren Schaltungsanordnungen (1, 1a) nach einem der Ansprüche 1 bis 12 und einer externen Steuereinheit (12), **dadurch gekennzeichnet, dass** die externe Steuereinheit (12) zum parallelen Steuern der zentralen und/oder dezentralen Steuereinheiten (21, 31, 41) geeignet und eingerichtet ist.

14. Netz nach Anspruch 13, **dadurch gekennzeichnet, dass** die externe Steuereinheit (12) ein Leitrechner ist.

15. Verfahren zum Betreiben eines Netzes aus einer oder mehreren Schaltungsanordnungen (1, 1a), insbesondere aus einem oder mehreren Wechselrichter (1) oder unterbrechungsfreien Stromversorgungen (1 a), mit einem Umrichterteil (2) umfassend eine Umrichtereinheit (20), eine zentrale Steuereinheit (21) und einen Eingang für den umzurichtenden Strom und einen Ausgang für den umgerichteten Strom und wenigstens einem Beschaltungsteil (3, 4), der dem Eingang des Umrichterteils vorgeschaltet oder dem Ausgang des Umrichterteils nachgeschaltet ist,
wobei an die Schaltungsanordnung wenigstens eine externe Steuereinheit (12) angeschlossen ist,
wobei die zentrale Steuereinheit (21) zum Empfang von Steueranweisungen der externen Steuereinheit (12) geeignet und eingerichtet ist,
wobei die externe Steuereinheit (12) an den Kommunikationsbus (13) angeschlossen ist,
wobei die externe Steuereinheit (12) zum parallelen Steuern der zentralen und/oder dezentralen Steuereinheiten (21, 31, 41) geeignet und eingerichtet ist,
**dadurch gekennzeichnet,**
**dass** jeder Beschaltungsteil (3, 4) wenigstens eine dezentralen Steuereinheit (31, 41) aufweist, die mit der zentralen Steuereinheit (21) über einen Kommunikationsbus (13) verbunden ist und zum Empfang von Steueranweisungen von der zentralen Steuereinheit (21), die eine übergeordnete Instanz darstellt, geeignet und eingerichtet ist, wobei die dezentrale Steuereinheit (31, 41) der zentralen Steuereinheit nachgeordnet ist,
**dass** die dezentrale Steuereinheit (31, 41) zum unmittelbaren Empfang von Steueranweisungen der externen Steuereinheit (12) geeignet und eingerichtet ist und
**dass** die externe Steuereinheit (12) bei Ausfall der zentralen Steuereinheit (21) einer der Schaltungsanordnungen (1, 1a) die dezentralen Steuereinheiten (31, 41) überwacht, regelt und/oder. steuert und insbesondere ausschaltet.

## Claims

1. Circuit arrangement (1, 1a), particularly inverter (1) or uninterruptable power supply (1a), having a converter element (2) comprising a converter unit (20), a central control unit (21) and an input for the current to be converted and an output for the converted current and at least one circuit element (3, 4) that is connected upstream of the input of the converter element or connected downstream of the output of the converter element, wherein the circuit arrangement has at least one external control unit (12) connectable to it and in that the central control unit (21) is suitable and set up for receiving control instructions from the external control unit (12),
**characterized**
**in that** each circuit element (3, 4) has at least one local control unit (31, 41) that is connected to the central control unit (21), which is a superordinate entity, via a communication bus (13) and is suitable and set up for receiving control instructions from the central control unit (21), wherein the local control unit (31, 41) is subordinated to the central control unit,
**in that** the external control unit (12) is connectable to the communication bus (13), and the local control unit (31, 41) is suitable and set up for directly receiving control instructions from the external control unit (12) so that the external control unit (12) can take action in the circuit arrangement (1, 1a) in the event of failure of a central control unit (21).

2. Circuit arrangement (1, 1a) according to Claim 1, **characterized in that** the circuit arrangement (1, 1a), particularly the converter element (2), has a communication unit (7, 8) that is arranged between the communication bus (13) and a connection of the circuit arrangement for the external control unit (12).

3. Circuit arrangement (1, 1a) according to Claim 2, **characterized in that** the connection of the circuit arrangement (1, 1a) for the external control unit (12) comprises an interface to a public communication network or a local area network (9).

4. Circuit arrangement (1, 1a) according to Claim 2 or 3, **characterized in that** the communication unit (7, 8) comprises an interface to the communication bus (13) and a driver circuit (11) for this interface.

5. Circuit arrangement (1, 1a) according to one of Claims 1 to 4, **characterized in that** the circuit element(s) (3, 4) has/have fuses (301, 401), switches (302, 402), particularly controllable switches, e.g. contactors (303, 403), measured variable pickups (304, 404), insulation monitors and much more.

6. Circuit arrangement (1, 1a) according to one of Claims 1 to 5, **characterized in that** the local control units (31, 41) are suitable and set up for providing measurement information obtained in the circuit element (3, 4) on the communication bus (9).

7. Circuit arrangement (1, 1a) according to one of Claims 1 to 6, **characterized in that** the circuit arrangement (1, 1a) has multiple switchgear cabinets, and the converter element (2) is arranged in a switchgear cabinet, and the circuit element (3, 4) or the circuit elements (3, 4) is/are arranged in respective separate switchgear cabinets.

8. Circuit arrangement (1, 1a) according to one of Claims 1 to 7, **characterized in that** the central control unit (21) and the local control units (31, 41) each have separate electric power supplies.

9. Circuit arrangement (1, 1a) according to Claim 8, **characterized in that** the local control units (31, 41) are additionally suppliable with electric power via the power supply of the central control unit (21).

10. Circuit arrangement (1, 1a) according to one of Claims 1 to 9, **characterized in that** the circuit arrangement (1, 1a) is an inverter (1) and has an input-side circuit element (3) and an output-side circuit element (4), wherein the input-side circuit element (3) is connectable to a generator, for example a solar generator (5), and the output-side circuit element is connectable to a power supply system (6).

11. Circuit arrangement (1, 1a) according to one of Claims 1 to 9, **characterized in that** the circuit arrangement (1, 1a) is an uninterruptable power supply (1) and has an output-side circuit element (4), wherein the converter element (2) is connectable to a generator (15), a store for electric power (14) or a power supply system (16) providing power, and the output-side circuit element is connectable to a system (6a) to be supplied with power.

12. Circuit arrangement (1, 1a) according to Claim 11, **characterized in that** the circuit arrangement (1, 1a) has a central electronic changeover device having a control unit, or a static transfer switch having a control unit, and this control unit forms the external control unit (12).

13. Network comprising one or more circuit arrangements (1, 1a) according to one of Claims 1 to 12 and an external control unit (12), **characterized in that** the external control unit (12) is suitable and set up for controlling the central and/or local control units (21, 31, 41) in parallel.

14. Network according to Claim 13, **characterized in that** the external control unit (12) is a control computer.

15. Method for operating a network comprising one or more circuit arrangements (1, 1a), particularly comprising one or more inverters (1) or uninterruptable power supplies (1a), having a converter element (2) comprising a converter unit (20), a central control unit (21) and an input for the current to be converted and an output for the converted current and at least one circuit element (3, 4) that is connected upstream of the input of the converter element or connected downstream of the output of the converter element,
wherein the circuit arrangement has at least one external control unit (12) connected to it,
wherein the central control unit (21) is suitable and set up for receiving control instructions from the external control unit (12),
wherein the external control unit (12) is connected to the communication bus (13),
wherein the external control unit (12) is suitable and set up for controlling the central and/or local control units (21, 31, 41) in parallel, **characterized**
**in that** each circuit element (3, 4) has at least one local control unit (31, 41) that is connected to the central control unit (21) via a communication bus (13) and is suitable and set up for receiving control instructions from the central control unit (21), which is a superordinate entity, wherein the local control unit (31, 41) is subordinated to the central control unit,
**in that** the local control unit (31, 41) is suitable and set up for directly receiving control instructions from the external control unit (12), and
**in that** the external control unit (12) monitors, regulates and/or controls and particularly switches off the local control units (31, 41) in the event of failure of the central control unit (21) of one of the circuit arrangements (1, 1a).

## Revendications

1. Arrangement de circuit (1, 1a), notamment onduleur (1) ou alimentation électrique ininterruptible (1a), pourvu d'une partie convertisseur (2) comprenant une unité de convertisseur (20), une unité de commande centrale (21) et une entrée pour le courant à convertir et une sortie pour le courant converti et au moins une partie de connexion (3, 4) qui est branchée en amont de l'entrée de la partie convertisseur ou branchée en aval de la sortie de la partie convertisseur, au moins une unité de commande externe (12) pouvant être raccordée à l'arrangement de circuit et en ce que l'unité de commande centrale (21) est adaptée et conçue pour recevoir des instructions de commande de l'unité de commande externe (12),
**caractérisé en ce**
**que** chaque partie de connexion (3, 4) possède au moins une unité de commande décentralisée (31, 41) qui est reliée à l'unité de commande centrale (21), laquelle représente une instance de superordonnée, par le biais d'un bus de communication (13) et est adaptée et conçue pour recevoir des instructions de commande de la part de l'unité de commande centrale (21), l'unité de commande décentralisée (31, 41) étant subordonnée à l'unité de commande centrale,
en ce que l'unité de commande externe (12) peut être raccordée au bus de communication (13) et l'unité de commande décentralisée (31, 41) est adaptée et conçue pour la réception directe d'instructions de commande de l'unité de commande externe (12).

2. Arrangement de circuit (1, 1a) selon la revendication 1, **caractérisé en ce que** l'arrangement de circuit (1, 1a), notamment la partie convertisseur (2), possède une unité de communication (7, 8) qui est disposée entre le bus de communication (13) et une borne de l'arrangement de circuit pour l'unité de commande externe (12).

3. Arrangement de circuit (1, 1a) selon la revendication 2, **caractérisé en ce que** la borne de l'arrangement de circuit (1, 1a) pour l'unité de commande externe (12) comprend une interface vers un réseau de communication public ou un réseau local (9).

4. Arrangement de circuit (1, 1a) selon la revendication 2 ou 3, **caractérisé en ce que** l'unité de communication (7, 8) comprend une interface vers le bus de communication (13) et un circuit de pilotage (7) pour cette interface.

5. Arrangement de circuit (1, 1a) selon l'une des revendications 1 à 4, **caractérisé en ce que** la ou les parties de connexion (3, 4) possèdent des fusibles (301, 401), des commutateurs (302, 402), notamment des commutateurs commandables, par exemple des contacteurs (303, 403), des enregistreurs de valeur mesurée (304, 404), des contrôleurs d'isolement et beaucoup plus.

6. Arrangement de circuit (1, 1a) selon l'une des revendications 1 à 5, **caractérisé en ce que** les unités de commande décentralisées (31, 41) sont adaptées et conçues pour mettre à disposition sur le bus de communication (9) les informations de mesure acquises dans la partie de connexion (3, 4).

7. Arrangement de circuit (1, 1a) selon l'une des revendications 1 à 6, **caractérisé en ce que** l'arrangement de circuit (1, 1a) possède plusieurs armoires électriques et la partie convertisseur (2) est disposée dans une armoire électrique et la partie de connexion (3, 4) ou les parties de connexion (3, 4) sont respectivement disposées dans des armoires électriques propres.

8. Arrangement de circuit (1, 1a) selon l'une des revendications 1 à 7, **caractérisé en ce que** l'unité de commande centrale (21) et les unités de commande décentralisées (31, 41) possèdent respectivement des alimentations en énergie électriques propres.

9. Arrangement de circuit (1, 1a) selon la revendication 8, **caractérisé en ce que** les unités de commande décentralisées (31, 41) peuvent en plus être alimentées en énergie électrique par le biais de l'alimentation en énergie de l'unité de commande centrale (21).

10. Arrangement de circuit (1, 1a) selon l'une des revendications 1 à 9, **caractérisé en ce que** l'arrangement de circuit (1, 1a) est un onduleur (1) et possède une partie de connexion côté entrée (3) et une partie de connexion côté sortie (4), la partie de connexion côté entrée (3) pouvant être raccordée à un générateur, par exemple un générateur solaire (5), et la partie de connexion côté sortie à un réseau de distribution (6).

11. Arrangement de circuit (1, 1a) selon l'une des revendications 1 à 9, **caractérisé en ce que** l'arrangement de circuit (1, 1a) est une alimentation électrique ininterruptible (1) et possède une partie de connexion côté sortie (4), la partie convertisseur (2) pouvant être raccordée à un générateur (15), un accumulateur d'énergie électrique (14) ou un réseau de distribution (6) qui délivre de l'énergie et la partie de connexion côté sortie à un réseau (6a) à alimenter.

12. Arrangement de circuit (1, 1a) selon la revendication 11, **caractérisé en ce que** l'arrangement de circuit (1, 1a) possède un dispositif d'inversion électronique central muni d'une unité de commande ou d'un commutateur de transfert statique avec une unité de commande, et cette unité de commande forme l'unité de commande externe (12).

13. Réseau composé d'un ou de plusieurs arrangements de circuit (1, 1a) selon l'une des revendications 1 à 12 et d'une unité de commande externe (12), **caractérisé en ce que** l'unité de commande externe (12) est adaptée et conçue pour commander en parallèle les unités de commande centrale et/ou décentralisées (21, 31, 41).

14. Réseau selon la revendication 13, **caractérisé en ce que** l'unité de commande externe (12) est un ordinateur pilote.

15. Procédé pour faire fonctionner un réseau composé d'un ou de plusieurs arrangements de circuit (1, 1a), notamment composé d'un ou de plusieurs onduleurs (1) ou alimentations électriques ininterruptibles (1a), pourvu d'une partie convertisseur (2) comprenant une unité de convertisseur (20), une unité de commande centrale (21) et une entrée pour le courant à convertir et une sortie pour le courant converti et au moins une partie de connexion (3, 4) qui est branchée en amont de l'entrée de la partie convertisseur ou branchée en aval de la sortie de la partie convertisseur,
au moins une unité de commande externe (12) étant raccordée à l'arrangement de circuit,
l'unité de commande centrale (21) étant adaptée et conçue pour recevoir des instructions de commande de l'unité de commande externe (12),
l'unité de commande externe (12) étant raccordée au bus de communication (13),
l'unité de commande externe (12) étant adaptée et conçue pour commander en parallèle les unités de commande centrale et/ou décentralisées (21, 31, 41),
**caractérisé en ce**
**que** chaque partie de connexion (3, 4) possède au moins une unité de commande décentralisée (31, 41) qui est reliée à l'unité de commande centrale (21) par le biais d'un bus de communication (13) et est adaptée et conçue pour recevoir des instructions de commande de la part de l'unité de commande centrale (21), laquelle représente une instance superordonnée, l'unité de commande décentralisée (31, 41) étant subordonnée à l'unité de commande centrale,
en ce que l'unité de commande décentralisée (31, 41) est adaptée et conçue pour la réception directe d'instructions de commande de l'unité de commande externe (12) et
en ce que l'unité de commande externe (12), en cas de panne de l'unité de commande centrale (21) de l'un des arrangements de circuit (1, 1a), surveille, régule et/ou commande et notamment met hors circuit les unités de commande décentralisées (31, 41).
